# EUROPÄISCHE PATENTSCHRIFT

(11) **EP 1 382 111 B1**
(45) Veröffentlichungstag und Bekanntmachung des Hinweises auf die Patenterteilung: **03.11.2004**
(21) Anmeldenummer: 02737807.4
(22) Anmeldetag: 19.04.2002
(51) Int. Cl.: H03D 1/00

(54) **HOCHFREQUENZEMPFÄNGER**
HIGH-FREQUENCY RECEIVER
RECEPTEUR HAUTE FREQUENCE

(30) Priorität: 27.04.2001 DE 10120702
(43) Veröffentlichungstag der Anmeldung: 21.01.2004
(73) Patentinhaber: Infineon Technologies AG, 81669 München (DE)
(72) Erfinder: ADLER, Bernd, 81827 München (DE)
(74) Vertreter: Epping Hermann & Fischer
(86) Internationale Anmeldenummer: PCT/DE2002/001455
(87) Internationale Veröffentlichungsnummer: WO 2002/089311

(56) Entgegenhaltungen:
- EP-A- 0 074 858
- EP-A- 0 335 037
- WO-A-96/25790
- US-A- 6 127 884

## Beschreibung

Die vorliegende Erfindung betrifft einen Hochfrequenzempfänger.

Moderne Hochfrequenzempfänger, wie sie beispielsweise im Mobilfunk eingesetzt werden, sind hohen Anforderungen bezüglich geringem Strombedarf, kleiner Chipfläche sowie hoher Linearität und geringem Rauschen unterworfen. Bei modernen hochintegrierten Receivern werden die benötigte Chipfläche sowie die Rausch- und Linearitätseigenschaften des Empfängers maßgeblich durch die Kanalfilterung bestimmt.

Bezüglich der Architektur von Hochfrequenzempfängern unterscheidet man Heterodynempfänger, bei denen ein Hochfrequenzsignal zunächst in ein Zwischenfrequenzsignal und anschließend in ein Basisbandsignal umgesetzt wird, und Homodynempfänger, bei denen ein Hochfrequenzsignal in einer Mischerstufe direkt in ein üblicherweise als komplexes Signal ausgebildetes Basisbandsignal überführt wird, welches eine Inphaseund eine Quadraturkomponente umfaßt.

In dem Dokument "A Fully Integrated Analog Baseband IC for an UMTS Zero-IF Receiver, W. Schelmbauer et al., Telematik, Zeitschrift des Telematik Ingenieur-Verband TIV, Best of AustroChip 2000, Jg. 6, Nummer 4/2000, S. 10 bis 13, ist eine für den Mobilfunkstandard UMTS, Universal Mobile Telecommunications Systems, geeignete Empfängerstruktur angegeben, welche dem Demodulator nachgeschaltet und einem A/D(Analog/-Digital)-Wandler vorgeschaltet ein Blockingfilter sowie ein Kanalfilter umfaßt. Das Blockingfilter dient zur Begrenzung von Amplituden verursacht durch Blockingstörer, während das Kanalfilter zum Herausfiltern beziehungsweise Unterdrücken von Nachbarkanalstörern ausgebildet ist.

Dieser herkömmliche Ansatz einer Mobilfunkempfängerstruktur hat jedoch den Nachteil, daß das Kanalfilter einen hohen Platzbedarf auf dem Chip erfordert und dieser Flächenbedarf auch nicht durch modernere Fertigungstechniken verringerbar ist, da die Filterfläche grundsätzlich von der üblicherweise mit RC-Konstanten gebildeten Grenzfrequenz abhängig ist.

Die Kanalfilter sind üblicherweise zeitkontinuierliche Filter und als RC-Operationsverstärkerfilter, gₘC- oder SC-Filter aufgebaut. Weitere Nachteile dieser Art der Kanalfilterung sind in der starken Abhängigkeit von Fertigungstoleranzen begründet, welche aufwendige Grenzfrequenzabgleichsschaltungen erfordern. Zudem wirkt sich Abhängigkeit der benötigten Chipfläche von der Grenzfrequenz sowie die Forderung nach guten Rauscheigenschaften nachteilig aus. Bei komplexer IQ-Signalverarbeitung kommt in der analogen Schaltungstechnik die weitere Problematik von sogenannten Mismatches oder Impairments der Analogfilter in Inphase- und Quadratur-Pfad hinzu. Wird zugunsten besserer Rauscheigenschaften eine schlechtere Linearität der Schaltung in Kauf genommen, um dennoch vertretbare Chipfläche zu erzielen, so führen die hierdurch verursachten nichtlinearen Verzerrungen zu einer hohen Stromaufnahme der Filterschaltung.

In dem Dokument EP 0204745 B2 ist ein Datenmodem angegeben, mit je einem Analog-/Digital-Wandler, dem je ein Digitalfilter nachgeschaltet ist, welches zur Signalaufbereitung ausgelegt ist. Hierfür ist das Digitalfilter mit einem Überlagerungs-Oszillator gekoppelt, mit dem ein Empfangssignal unter Verwendung von Umsetzern in ein Quadratursignal zerlegt wird. Die Digitalfilter dienen zur Korrektur von Phasenfehlern.

Das Dokument EP 0 335 037 A beispielsweise zeigt zwar einen Hochfrequenzempfänger mit einem dem Abwärtsmischer nachgeschalteten Anti-Aliasing-Filter und in der weiteren Signalverarbeitung nachgeschaltetem A/D-Wandler und weiteren digitalen Filtern, zeigt aber keinerlei Abgleichschaltung zum Abgleich des Anti-Aliasing-Filters.

Aufgabe der vorliegenden Erfindung ist es, einen Hochfrequenzempfänger anzugeben, der bezüglich Rauscheigenschaften und Linearität verbessert ist und mit geringer Stromaufnahme und geringem Chipflächenbedarf aufgebaut werden kann.

Erfindungsgemäß wird die Aufgabe gelöst durch einen Hochfrequenzempfänger, aufweisend
- einen Frequenzumsetzer, dem eingangsseitig ein Hochfrequenzsignal zuführbar ist und der an einem Ausgang ein Basisbandsignal bereitstellt,
- ein Analogfilter, das den Ausgang des Frequenzumsetzers mit einem Eingang eines Analog/Digital-Wandlers koppelt und
- ein Digitalfilter, das als Kanalfilter ausgebildet ist und an einen Ausgang des Analog/Digital-Wandlers angeschlossen ist, zur Bereitstellung eines digitalen kanalgefilterten Basisbandsignals.

Der beschriebene Hochfrequenzempfänger ist insbesondere für homodyne Empfangsarchitekturen von Mobilfunk-Empfängern, beispielsweise der dritten Generation (UMTS), geeignet.

Das Analogfilter ist bevorzugt als Blockingfilter ausgelegt, während das Digitalfilter zum einen zur Entzerrung des Analogfilters dient und zum anderen zur Kanalfilterung. Da die Verstärkungsfaktoren des bevorzugt aktiv ausgelegten Digitalfilters programmierbar sind, ist eine hohe Flexibilität gewährleistet. Die beschriebene Hochfrequenzempfängerarchitektur ermöglicht gute Rauscheigenschaften sowie gute Linearitätseigenschaften.

Da ein großer Teil der üblicherweise flächenintensiven Filterfunktionen nicht mehr analog ausgeführt ist, sondern im Digitalfilter implementiert ist, kann der beschriebene Hochfrequenzempfänger mit geringer Chipfläche aufgebaut sein. Zudem bietet die digitale Filterrealisierung die Möglichkeit, bei zukünftigen Fertigungsprozessen in der Halbleitertechnik eine höhere Integrationsdichte mit noch geringerem Flächenbedarf der Schaltung zu erzielen.

Das Digitalfilter kann neben einer Kanalfilterung zusätzlich eine Signalentzerrung umfassen, beispielsweise zur Entzerrung linearer Inband-Phasen- und Amplitudenverzerrungen.

In einer bevorzugten Ausführungsform der vorliegenden Erfindung ist das Analogfilter ein ausschließlich passives Filter.

Zur Bildung passiver Polstellen für die analoge Filterung ist kein nennenswerter zusätzlicher Schaltungsaufwand erforderlich, da die ohnehin als Lastwiderstände von Mischern oder Verstärkern vorhandenen Kollektorwiderstände in einfacher Weise zur Bildung von RC-Konstanten und damit passiven Filterpolen heranziehbar sind. Zudem bietet die passive Filterung den Vorteil der geringen Stromaufnahme und insgesamt eine deutliche Reduzierung der Gesamtchipfläche durch einfachen Aufbau des Analogteils.

In einer weiteren, bevorzugten Ausführungsform der vorliegenden Erfindung umfaßt das Analogfilter einen ersten Filterabschnitt zur Bildung einer ersten Polstelle, der einerseits an einen Ausgang des Mischers und andererseits an einen Eingang eines Basisband-Verstärkers angeschlossen ist, und das Analogfilter umfaßt einen zweiten Filterabschnitt zur Bildung einer zweiten Polstelle, der einerseits an einem Ausgang des Basisband-Verstärkers angeschlossen und andererseits mit dem Analog/Digital-Wandler gekoppelt ist.

Zur Bildung dieser passiven Polstellen kann demnach zum einen der ausgangsseitige Kollektorwiderstand des Analogmischers beziehungsweise Frequenzumsetzers und zum anderen der ausgangsseitige Kollektorwiderstand des Verstärkers, welche üblicherweise ohnehin bei in Analogtechnik aufgebauten Mischern und Verstärkern vorhanden sind, mitverwendet werden.

In einer weiteren, bevorzugten Ausführungsform der vorliegenden Erfindung ist ein dritter Filterabschnitt zur Bildung einer dritten Polstelle zwischen zweiten Filterabschnitt und Analog/Digital-Wandler geschaltet.

Der dritte Filterabschnitt ist bevorzugt als in Abhängigkeit von der gewünschten Abtastfrequenz ausgebildetes Antialiasing-Filter vorgesehen, das schaltungstechnisch vor dem Analog/-Digital-Wandler angeordnet ist.

In einer weiteren, bevorzugten Ausführungsform der vorliegenden Erfindung ist eine Abgleichschaltung zur Kompensation von Toleranzen des Analogfilters vorgesehen mit einem analog aufgebauten Referenz-Filterelement, welches über eine Ansteuerschaltung mit dem Digitalfilter gekoppelt ist.

Bei der bereits beschriebenen, passiven Ausführung des Analogfilters, das heißt der Bildung passiver Polstellen mit RC-Gliedern, ist das Referenz-RC-Glied bevorzugt aus den gleichen Einheitselementen, beispielsweise Widerständen und Kondensatoren, wie die passiven Pole aufgebaut, um die sich gegebenenfalls aus Fertigungstoleranzen von Widerständen und Kondensatoren ergebenden Parameterstreuungen beziehungsweise Parameterabweichungen von Soll-Werten, beispielsweise Abweichungen der Grenzfrequenz, sicher und präzise zu erfassen. Mit der Ansteuerschaltung kann dann in einfacher Weise ein vorzunehmender Abgleich mittels Widerstands- oder Kapazitätsbänken hergeleitet werden, mit dem die digitale Übertragungsfunktion des Digitalfilters in geeigneter Weise kompensierend beeinflußbar ist. Insgesamt ermöglicht die beschriebene Kompensation einen Verzicht auf aufwendig zu implementierende, analog aufgebaute Kompensations- beziehungsweise Rückkopplungsschaltungen.

In einer weiteren, bevorzugten Ausführungsform der vorliegenden Erfindung ist das Digitalfilter zur Bildung zumindest eines konjungiert komplexen Polpaares ausgelegt. Die Bildung der konjungiert komplexen Polpaare in aktiven Filterelementen im digitalen Schaltungsteil anstelle des analogen Schaltungsteils durch entsprechende Realisierung der sogenannten Bi-Quads führt zu einer deutlich geringeren Chipfläche sowie der Vermeidung der Abhängigkeit von Filterparametern von Fertigungsschwankungen. Zudem ist eine Skalierung des Digitalfilters nach unten, ein sogenanntes Shrinking, möglich, so daß eine hohe Flexibilität des Schaltungskonzepts im Hinblick auf zukünftige Fertigungsprozesse gegeben ist.

In einer weiteren, bevorzugten Ausführungsform der vorliegenden Erfindung umfaßt der Empfänger zur Bildung einer komplexen Signalverarbeitung einen Inphase- und einen Quadratursignalpfad. In einem derartigen, mit I- und Q-Pfaden realisierten Hochfrequenzempfänger sind die beschriebenen Analogfilterteile, beispielsweise ausgebildet als passive Polstellen, jeweils einmal pro Inphase- und Quadratur-Signalpfad.

In einer weiteren, bevorzugten Ausführungsform der vorliegenden Erfindung umfaßt das Digitalfilter einen Integrator zur Bestimmung der Empfangsfeldstärke des Hochfrequenz-Empfängers.

Anstelle dieser Empfangsfeldstärkebestimmung können auch Realisierungen für andere oder zusätzliche Rechenoperationen vorgesehen sein. Weiterhin ermöglicht eine Programmierbarkeit des Digitalfilters die Unterstützung einer Multisystem- oder Multimode-Filterung, wie sie in modernen Mobilfunksystemen gefordert ist.

Zudem ermöglicht die digitale Signalverarbeitung, in der das Digitalfilter gebildet sein kann, umfangreiche anpassende Einstellmöglichkeiten im Betrieb des Empfängers und hierdurch ein Stromsparpotential aufgrund der jeweiligen Empfangssituation des Hochfrequenz-empfängers. Insbesondere bei in CMOS-Schaltungstechnik aufgebauten Hochfrequenzempfängern ist mit dem angegebenen Empfänger eine deutliche Flächenersparnis des Analogfilters und damit des Empfängers insgesamt gegeben.

Da die Filterpole hoher Güte im Digitalfilter realisiert sein können, ermöglicht vorliegendes Empfängerkonzept die Vermeidung von durch IQ-Mismatch (Fehlanpassung) herrührenden Problemen bei hohen Filterpolgüten, wie sie in Analogfiltern auftreten können.

Ein optionales IQ-Multiplexing kann eine weitere Reduzierung der Mismatches der Filter ermöglichen.

Da der Toleranzabgleich des Analogteils im nachfolgenden Digitalteil ausgeführt werden kann, entfällt ein aufwendiges analoges oder quasi-analoges Filtertuning.

Ist der Empfänger als IQ-Empfänger aufgebaut, so ermöglicht eine Überabtastung des Signals sowie ein IQ-Multiplexing die Benutzung des Digitalfilters sowohl für den I-Signalpfad als auch für den Q-Signalpfad. Hierdurch ist eine weitere Reduzierung der Chipfläche möglich.

Weitere Einzelheiten der Erfindung sind Gegenstand der Unteransprüche.

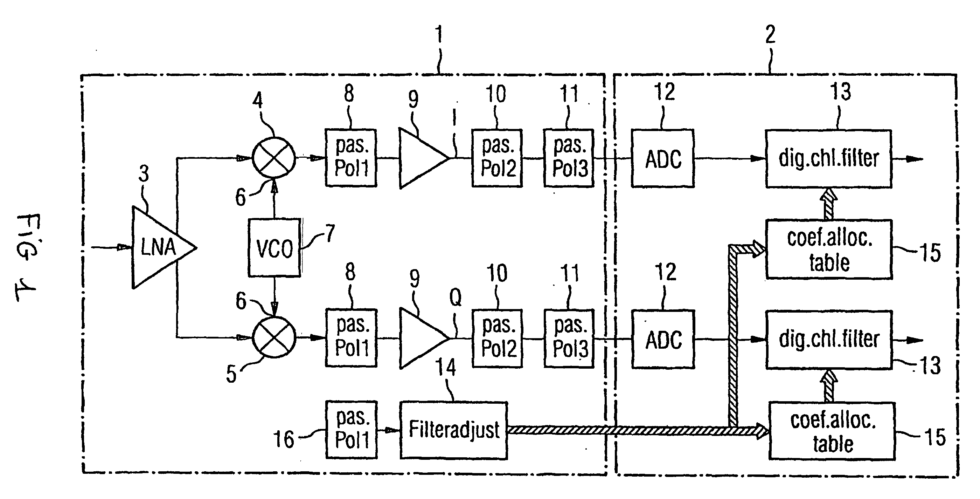

Die Erfindung wird nachfolgend an einem Ausführungsbeispiel anhand der Figur näher erläutert.

Es zeigt:
die Figur ein erstes Ausführungsbeispiel des erfindungsgemäßen Hochfrequenzempfängers anhand eines Blockschaltbilds.

Die Figur zeigt ein Blockschaltbild eines erfindungsgemäßen, homodyn aufgebauten Hochfrequenzempfängers, der für Mobilfunksysteme der dritten Generation (UMTS, Universal Mobile Telecommunications System) UTRA FDD (UMTS Terrestrial Radio Access Frequency Division Duplex) geeignet ist.

Die Figur umfaßt einen analogen Schaltungsteil 1, sowie einen digital aufgebauten Schaltungsteil 2, der dem analogen Schaltungsteil 1 nachgeschaltet ist. Der Analogteil 1 umfaßt einen rauscharmen Vorverstärker 3, englisch Low-Noise Amplifier, LNA, an dem ein Hochfrequenzsignal eingangsseitig zuführbar ist, welches beispielsweise über eine Antenne und ein Bandpaßfilter einkoppelbar ist. Ausgangsseitig ist der rauscharme Vorverstärker 3 zum einen mit einem ersten Mischer 4 und zum anderen mit einem zweiten Mischer 5 jeweils an deren Signaleingängen verbunden. Die Mischer 4, 5 weisen jeweils zusätzlich einen Lokaloszillator-Eingang 6 auf, der mit einem Oszillator 7, beispielsweise einem spannungsgesteuerten Oszillator, zur Erzeugung eines Lokaloszillatorsignals verbunden ist. Das Lokaloszillatorsignal wird dabei einem der Mischer 4 unverändert und einem weiteren der Mischer 5 um 90° phasenverschoben zugeführt, um die Weiterverarbeitung des ins Basisband umgesetzten Hochfrequenzsignals als komplexes, in Inphase- und Quadraturkomponente I, Q zerlegte Signal sicherzustellen. Ausgangsseitig an den Mischern 4, 5 ist jeweils ein erstes Analogfilter 8 zur Bildung einer ersten passiven Polstelle angeschlossen. Dieser erste passive Pol wird am Demodulatorausgang unter Verwendung der als Arbeitswiderstände funktionierenden Kollektorwiderstände des Demodulators erzeugt, beispielsweise durch einfaches Hinzuschalten einer Kapazität zur Bildung eines RC-Gliedes mit dem Kollektorwiderstand. Ausgangsseitig an diesem ersten Filterabschnitt 8 ist ein Basisbandverstärker 9 jeweils im I- und Q-Pfad angeschlossen, der als rauscharmer Verstärker ausgebildet ist. Ausgangsseitig an diesem Verstärker 9 ist jeweils ein zweiter Filterabschnitt 10 zur Bildung einer zweiten passiven Polstelle angeschlossen. Dieser zweite Pol wird an den Kollektorwiderständen des rauscharmen Basisbandverstärkers 9 ebenfalls beispielweise durch geeignetes Hinzuschalten je einer Kapazität zur Bildung eines RC-Gliedes geschaffen. Ausgangsseitig an dem zweiten Filterabschnitt 10 ist jeweils in I-und Q-Signalpfad I, Q ein dritter Filterabschnitt 11 angeschlossen zur Bildung eines Antialiasing-Filters in Abhängigkeit der Abtastfrequenz (Sampling Frequenz) des nachgeschalteten Analog/Digital-Wandlers. Dieser dritte Filterabschnitt 11 dient zur Bildung je einer dritten passiven Polstelle und kann in alternativen Ausführungsformen auch entfallen.

Ausgangsseitig an den zweiten beziehungsweise dritten Filterabschnitt 10, 11 ist in I- und Q-Signalpfad jeweils ein Analog/Digital-Wandler 12 angeschlossen, der digital aufgebaut und damit vom digitalen Schaltungsteil 2 umfaßt ist. Diese wandeln das analoge Basisbandsignal in ein digitales Basisbandsignal zur digitalen Weiterverarbeitung um. Ausgangsseitig an den AD-Wandlern 12 ist je ein in einer digitalen Signalverarbeitung realisiertes, digitales Kanalfilter 13 angeschlossen, welches je einen Steuereingang zur Beeinflussung der Übertragungsfunktion des Filters 13 aufweist. An den Steuereingängen der Digitalfilter 13 ist jeweils eine Ansteuerschaltung 14, 15 zur Bereitstellung von Programmier- und Abstimmfunktionen der Filtereigenschaften des Empfängers angeschlossen.

Im Einzelnen umfaßt die Abgleichschaltung ein in analoger Schaltungstechnik aufgebautes Referenzglied 16, das zur Reproduktion von Fertigungsschwankungen gleich aufgebaute Widerstände und Kondensatoren umfaßt wie die passiven Polstellen 8, 10, 11, mit einer nachgeschalteten Anpaßschaltung 14, welche eine Abweichung von sich aus eventuellen Parameterstreuungen bei der Fertigung ergebenden Abweichungen von Sollwerten auswertet und ein entsprechendes Abgleichwort an eine Ansteuerschaltung 15 der digitalen Kanalfilter 13 übermittelt. Die Ansteuerschaltungen 15 weisen hierfür sogenannte Allocation Tables für die digitalen Filterverstärkungsfaktoren auf. Mit dieser Information kann die Übertragungsfunktion des jeweils zugehörigen Digitalfilters 13 zur Kompensation der Analogfiltertoleranzen beeinflußt werden. Hierdurch ist ein deutlich verbessertes Großsignalverhalten des Hochfrequenzempfängers gewährleistet.

Zur Einstellung der Grenzfrequenzen der passiven Polstellen 8, 10, 11 sind die auftretenden maximalen Spannungshübe an den Kollektoranschlüssen von Mischern 4, 5 und Verstärkern 9 so einzustellen, daß keine Übersteuerung der Verstärkerstufen auftritt. Die Polfrequenzen können hierbei deutlich unterhalb der Kanalbandbreite liegen, da eine Kompensation der Übertragungskennlinie mittels der zugehörigen Digitalfilter 13 realisiert ist.

Die Digitalfilter 13 umfassen jeweils eine Kompensation der analog gebildeten passiven Polstellen 8, 10, 11. Die ersten beiden Polstellen 8, 10 werden jeweils mit einem digital aufgebauten BiQuad als zwei hintereinandergeschaltete Filter von zumindest dritter Ordnung kompensiert. Diese sind digital aufgebaut und weisen üblicherweise eine passive Polstelle sowie ein in einem aktiven Filter gebildetes, konjungiert komplexes Polpaar auf. Die dritte Polstelle, gebildet im dritten Filterabschnitt 11 im Analogteil 1 wird in den Digitalfiltern 13 ebenfalls mittels eines digitalen Hochpaßfilters kompensiert, der zu einem Allpaßfilter mit integriertem digitalen Hochpaß ergänzt ist, der zugleich entstehende DC(Gleichspannungs)-Offsets herausfiltert.

Nachfolgend ist eine Tabelle zur Erläuterung der Auslegung der Grenzfrequenzen der passiven Polstellen sowie der erforderlichen Filtercharakteristiken in Abhängigkeit der Bitanzahl der digitalen Signalverarbeitung angegeben.

Neben geringer Chipfläche und geringer Stromaufnahme durch die deutliche Verringerung der im analogen Schaltungsteil realisierten Filterfunktionen und deren Realisierung in Digitalfilter bietet vorliegende Empfängerschaltung zusätzlich eine verringerte Abhängigkeit von Fertigungsparameterschwankungen sowie außerdem eine Kompensation der gegebenenfalls übrigbleibenden Parameterabhängigkeiten. Zusätzlich ist aufgrund der Programmierbarkeit des Digitalfilters eine hohe Flexibilität des Empfängers sowie eine Anpaßbarkeit an verschiedene Übertragungsverfahren und Mobilfunkstandards gegeben.

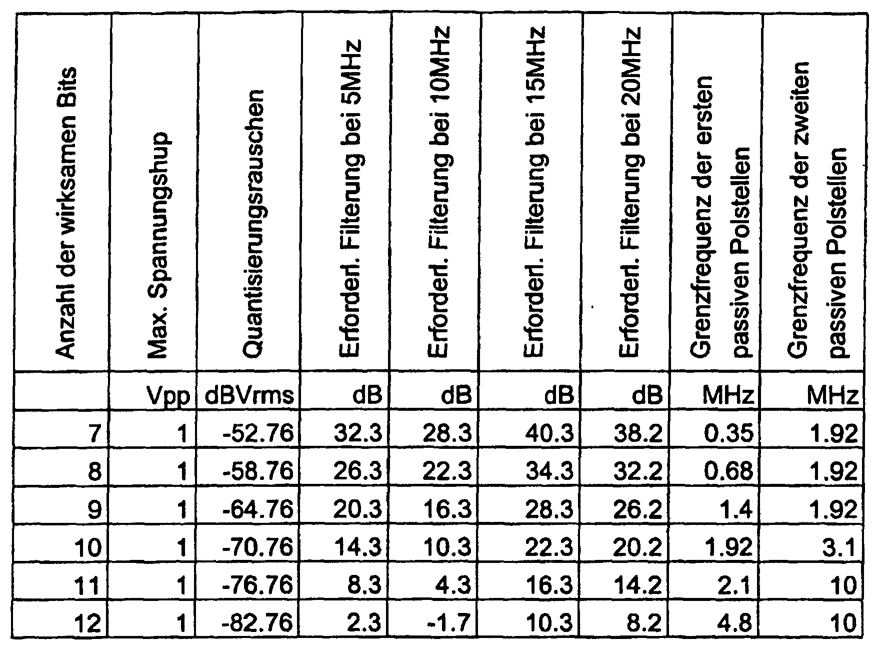

Neben guten Rauscheigenschaften weist vorliegender Empfänger zusätzlich gute Linearitätseigenschaften sowie geringe Stromaufnahme auf.

### Bezugszeichenliste

- 1: Analogteil
- 2: Digitalteil
- 3: rauscharmer Vorverstärker
- 4: Mischer
- 5: Mischer
- 6: Lokaloszillatoreingang
- 7: spannungsgesteuerter Oszillator
- 8: passive Polstelle
- 9: rauscharmer Verstärker
- 10: passive Polstelle
- 11: passive Polstelle
- 12: A/D-Wandler
- 13: Digitalfilter
- 14: Filter-Anpaßschaltung
- 15: Ansteuerschaltung
- 16: Referenzglied
- I: Inphase-Signalpfad
- Q: Quadratur-Signalpfad

## Patentansprüche

1. Hochfrequenzempfänger, aufweisend
- einen Frequenzumsetzer (4, 5), dem eingangsseitig ein Hochfrequenzsignal zuführbar ist und der an einem Ausgang ein Basisbandsignal bereitstellt,
- ein Analogfilter (8, 10, 11), das den Ausgang des Frequenzumsetzers (4, 5) mit einem Eingang eines Analog/Digital-Wandlers (12) koppelt und
- ein Digitalfilter (13), das als Kanalfilter ausgebildet und an einen Ausgang des Analog/Digital-Wandlers (12) angeschlossen ist, zur Bereitstellung eines digitalen kanalgefilterten Basisbandsignals, wobei eine Abgleichschaltung (14, 15, 16) zur Kompensation von Toleranzen des Analogfilters (8, 10, 11) vorgesehen ist mit einem analog aufgebauten Referenz-Filterelement (16), welches über eine Ansteuerschaltung (15) mit dem Digitalfilter (13) gekoppelt ist.

2. Hochfrequenzempfänger nach Anspruch 1,
**dadurch gekennzeichnet, daß**
das Analogfilter (8, 10, 11) ein ausschließlich passives Filter ist.

3. Hochfrequenzempfänger nach Anspruch 1 oder 2,
**dadurch gekennzeichnet, daß**
- das Analogfilter (8, 10, 11) einen ersten Filterabschnitt (8) zur Bildung einer ersten Polstelle umfaßt, der einerseits an den Ausgang des Mischers (4, 5) und andererseits an einen Eingang eines Basisband-Verstärkers (9) angeschlossen ist, und daß
- das Analogfilter (8, 10, 11) einen zweiten Filterabschnitt (10) zur Bildung einer zweiten Polstelle umfaßt, der einerseits an einen Ausgang des Basisbandverstärkers (9) angeschlossen und andererseits mit dem Analog/Digital-Wandler (12) gekoppelt ist.

4. Hochfrequenzempfänger nach Anspruch 3,
**dadurch gekennzeichnet, daß**
ein dritter Filterabschnitt (11) zur Bildung einer dritten Polstelle zwischen zweiten Filterabschnitt (10) und Analog/Digital-Wandler (12) geschaltet ist.

5. Hochfrequenzempfänger nach einem der Ansprüche 1 bis 4,
**dadurch gekennzeichnet, daß**
das Digitalfilter (13) zur Bildung zumindest eines konjungiert komplexen Polpaares ausgelegt ist.

6. Hochfrequenzempfänger nach einem der Ansprüche 1 bis 5,
**dadurch gekennzeichnet, daß**
der Empfänger einen Inphase- (I) und einen Quadratur-Signalpfad (Q) zur Verarbeitung komplexer Signale umfaßt.

7. Hochfrequenzempfänger nach einem der Ansprüche 1 bis 6,
**dadurch gekennzeichnet, daß**
das Digitalfilter (13) einen Integrator zur Bestimmung der Empfangsfeldstärke des Hochfrequenzempfängers umfaßt.

## Claims

1. Radio frequency receiver, comprising
- a frequency converter (4, 5) to which a radio frequency signal can be applied to its input and which provides a baseband signal at an output,
- an analog filter (8, 10, 11) that couples the output of the frequency converter (4, 5) to an input of an analog/digital converter (12), and
- a digital filter (13) that is designed as a channel filter and is connected to an output of the analog/digital converter (12) to provide a digital channel-filtered baseband signal, a compensation circuit (14, 15, 16) for compensating for tolerances in the analog filter (8, 10, 11) being provided, having a reference filter element (16) designed in analog technology that is coupled to the digital filter (13) via a control circuit (15).

2. Radio frequency receiver according to Claim 1,
**characterized in that**
the analog filter (8, 10, 11) is a solely passive filter.

3. Radio frequency receiver according to Claim 1 or 2,
**characterized in that**
- the analog filter (8, 10, 11) contains a first filter section (8) for creating a first pole point, said filter section being connected on one side to the output of the mixer (4, 5), and on the other side to an input of a baseband amplifier (9), and that
- the analog filter (8, 10, 11) contains a second filter section (10) for creating a second pole point, said filter section being connected on one side to an output of the baseband amplifier (9), and on the other side to the analog/digital converter (12).

4. Radio frequency receiver according to Claim 3,
**characterized in that**
a third filter section (11) for creating a third pole point is connected between second filter section (10) and analog/digital converter (12).

5. Radio frequency receiver according to one of the Claims 1 to 4,
**characterized in that**
the digital filter (13) is designed to create at least one complex-conjugated pole pair.

6. Radio frequency receiver according to one of the Claims 1 to 5,
**characterized in that**
the receiver comprises an in-phase (I) and a quadrature signal path (Q) for processing complex signals.

7. Radio frequency receiver according to one of the Claims 1 to 6,
**characterized in that**
the digital filter (13) contains an integrator for determining the received field strength of the radio frequency receiver.

## Revendications

1. Récepteur à haute fréquence, comportant
- un convertisseur de fréquence (4, 5) à l'entrée duquel est amené un signal de haute fréquence et qui délivre à une sortie un signal de bande de base,
- un filtre analogique (8, 10, 11) qui couple la sortie du convertisseur de fréquence (4, 5) à une entrée d'un convertisseur analogique/numérique (12) et
- un filtre numérique (13) qui est conformé en filtre de canal et qui est raccordé à une sortie du convertisseur analogique/numérique (12) afin de délivrer un signal de bande de base numérique filtré par canal, un circuit de compensation (14, 15, 16) étant prévu pour compenser les tolérances du filtre analogique (8, 10, 11) avec un élément de filtrage de référence (16) de structure analogique qui est couplé au filtre numérique (13) via un circuit de commande (15).

2. Récepteur à haute fréquence selon la revendication 1, **caractérisé en ce que** le filtre analogique (8, 10, 11) est un filtre exclusivement passif.

3. Récepteur de haute fréquence selon la revendication 1 ou 2, **caractérisé en ce que**
- le filtre analogique (8, 10, 11) comporte une première section de filtrage (8) destinée à former un premier pôle qui est raccordé d'une part à la sortie du mélangeur (4, 5) et d'autre part à une entrée d'un amplificateur de bande de base (9), et **en ce que**
- le filtre analogique (8, 10, 11) comporte une deuxième section de filtrage (10) destinée à former un deuxième pôle qui est raccordé d'une part à une sortie de l'amplificateur de bande de base (9) et qui est couplé d'autre part au convertisseur analogique/numérique (12).

4. Récepteur de haute fréquence selon la revendication 3, **caractérisé en ce qu'**une troisième section de filtrage (11) destinée à former un troisième pôle est monté entre la deuxième section de filtrage (10) et le convertisseur analogique/numérique (12).

5. Récepteur de haute fréquence selon l'une des revendications 1 à 4, **caractérisé en ce que** le filtre numérique (13) est conçu pour former au moins une paire de pôles complexes conjugués.

6. Récepteur de haute fréquence selon l'une des revendications 1 à 5, **caractérisé en ce que** le récepteur comporte un chemin de signal en phase (I) et un chemin de signal en quadrature (Q) pour le traitement de signaux complexes.

7. Récepteur de haute fréquence selon l'une des revendications 1 à 6, **caractérisé en ce que** le filtre numérique (13) comporte un intégrateur destiné à déterminer l'intensité de champ de réception du récepteur de haute fréquence.
